# EUROPÄISCHE PATENTSCHRIFT

(11) **EP 2 035 838 B1**
(45) Veröffentlichungstag und Bekanntmachung des Hinweises auf die Patenterteilung: **28.02.2018**
(21) Anmeldenummer: 07728490.9
(22) Anmeldetag: 25.04.2007
(51) Int. Cl.: H02H 3/24, G01R 19/165

(54) **SCHALTUNGSANORDNUNG ZUR UNTERSPANNUNGSERKENNUNG EINER ENERGIEQUELLE**
CIRCUIT ARRANGEMENT FOR RECOGNIZING AN UNDERVOLTAGE OF AN ENERGY SOURCE
CIRCUIT POUR IDENTIFIER UNE BASSE TENSION DE SOURCE D'ÉNERGIE

(30) Priorität: 20.06.2006 DE 102006028708
(43) Veröffentlichungstag der Anmeldung: 18.03.2009
(73) Patentinhaber: Robert Bosch GmbH, 70442 Stuttgart (DE)
(72) Erfinder: LOHR, Guenter, 70771 Leinfelden-Echterdingen (DE); KYNAST, Andreas, 70176 Stuttgart (DE)
(86) Internationale Anmeldenummer: PCT/EP2007/054034
(87) Internationale Veröffentlichungsnummer: WO 2007/147666

(56) Entgegenhaltungen:
- DE-A1- 1 463 539
- JP-A- 1 303 053
- US-A- 4 829 290
- US-A- 5 175 487
- US-A- 5 959 436

## Beschreibung

Die Erfindung betrifft eine Schaltungsanordnung zur Unterspannungserkennung einer Energiequelle nach der Gattung des unabhängigen Anspruchs.

### Stand der Technik

Insbesondere bei akkubetriebenen, elektrischen Geräten stellt eine Unterspannungserkennung eine wichtige Funktion dar. So kann durch eine entsprechende Schaltungsanordnung eine Tiefenentladung des Akkus vermieden werden. Da es bestimmte elektrische Bauelemente und Schaltungen gibt, die bei einer zu geringen Versorgungsspannung fehlerhaft arbeiten, kann eine Unterspannungserkennung auch in Verbindung mit anderen Energiequellen sehr hilfreich sein.

Aus der EP-A-0698794 A ist eine Schaltungsanordnung zur Unterspannungserkennung einer Energiequelle mit einer von der Energiequelle gespeisten Referenzspannungsquelle bekannt, deren Ausgang einem ersten Eingang eines Komparators zugeführt wird. Die Schaltungsanordnung verfügt weiterhin über Mittel zum Spannungsteilen der von der Energiequelle gelieferten Spannung, deren Ausgangsspannung einem zweiten Eingang des Komperators zugeführt wird, wobei an einem Ausgang des Komparators ein Detektionssignal abgreifbar ist, mit dessen Hilfe ein elektrisches Gerät im Falle einer Unterspannung deaktiviert werden kann.

Entsprechende, eine Referenzspannungquelle sowie einen Komparator aufweisende Schaltungsanordnungen sind unter anderem auch bekannt aus der US-A-3670246, der EP-A-ß2ß7159 und der US-A-5508874. Diesen Schaltungsanordnungen gemein ist ein relativ großer Bauteileaufwand, da unter anderem die Referenzspannungsquellen verhältnismäßig komplex aufgebaut sind. US 5 175 487 A und JP 1 303053 A stellen weitere Beispiele des Standes der Technik dar.

### Offenbarung der Erfindung

Gegenüber dem Stand der Technik bietet die erfindungsgemäße Schaltunganordnung laut dem Anspruch 1 den Vorteil eines sehr einfachen und kostengünstigen Aufbaus sowie einer sehr geringen Stromaufnahme nach einer erfolgten Unterspannungsabschaltung. Dazu sind der Transistorschalter und das weitere Schaltmittel in einem Betriebszustand der Schaltungsanordung niederohmig, wobei der Transistorschalter das weitere Schaltmittel zur Unterbrechung der Spannungsversorgung sperrt, wenn eine Versorgungsspannung der Energiequelle einen definierten Spannungswert unterschreitet. Somit ist sehr einfach und kostengünstig eine Tiefenentladung eines als Energiequelle verwendeten Akkus sowie eine Beschädigung eines mit der Energiequelle betriebenen elektrischen Geräts vermeidbar.

Weitere Vorteile der Erfindung ergeben sich durch die in den abhängigen Ansprüchen angegebenen Merkmale sowie aus der Zeichnung und der nachfolgenden Beschreibung. Der definierte Spannungswert ist aus der Summe einer Zenerspannung einer Z-Diode und einer Schwellspannung des Transistorschalters gebildet, so dass auf eine aufwändige und kostenintensive Referenzspannungsquelle sowie einen entsprechend ausgelegten Komparator verzichtet werden kann. Die Überwachung der Versorgungsspannung erfolgt mittels eines Spannungteilers, der mit dem Transistorschalter verbunden ist, wobei der Transistorschalter sperrt, wenn die mittels des Spannungsteilers überwachte Versorgungsspannung unter den definierten Spannungswert fällt. Diesbezüglich ist der Transistorschalter als ein NPN-Bipolartransistor ausgebildet, wobei die Basis des Bipolartransistors mit dem Spannungsteiler, der Emitter des Bipolartransistors mit der Kathode der Z-Diode und der Kollektor des Bipolartransistors mit einem Schalteingang des weiteren Schaltmittels verbunden ist. Somit ist es möglich, eine Unterspannungserkennung und -abschaltung mit nur zwei elektrisch angesteuerten Schaltmitteln zu realisieren. Dabei kann das weitere Schaltmittel beispielsweise ein Transistor oder ein Relais sein.

Das Zurücksetzen der Schaltungsanordnung nach erfolgter Unterspannungsabschaltung in den ursprünglichen Betriebszustand erfolgt mittels eines Umschalters oder Tasters. Handelt es sich bei dem elektrischen Gerät beispielsweise um ein Elektrowerkzeug, so kann dessen Ein/Aus- bzw. Hauptschalter als Umschalter oder Taster fungieren, so dass kein weiteres Bedienelement erforderlich ist.

In vorteilhafter Weise ist die Schaltungsanordnung als Bestandteil des elektrischen Geräts ausgeführt. Es ist aber auch möglich, dass sie Teil der Energiequelle ist.

### Zeichnung

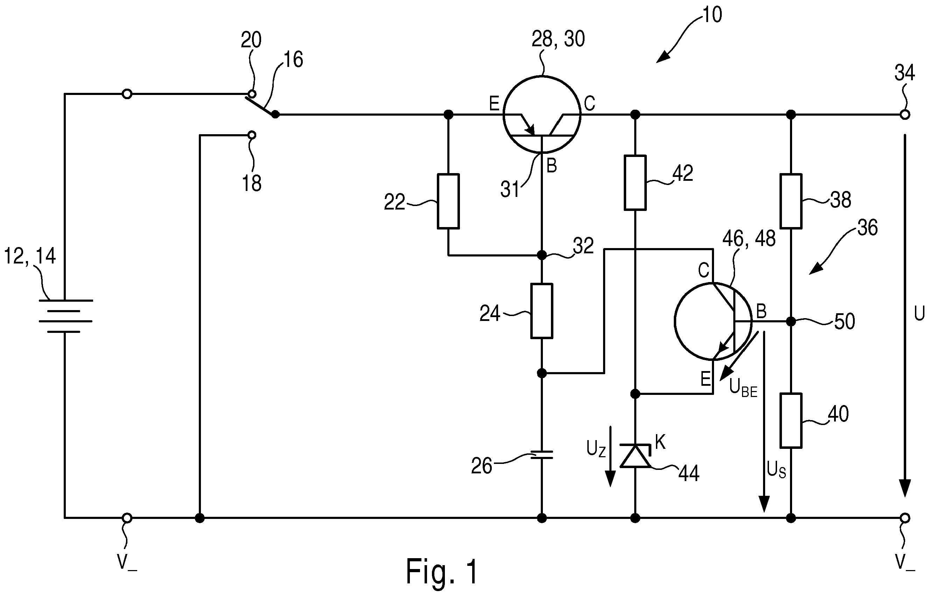

Die Erfindung wird im Folgenden anhand der einzigen Figur beispielhaft erläutert. Die Beschreibung sowie die Ansprüche enthalten zahlreiche Merkmale in Kombination. Die Erfindung ist durch die Ansprüche definiert. Es zeigt
Fig. 1: ein Blockschaltbild der erfindungsgemäßen Schaltungsanordnung zur Unterspannungserkennung einer Energiequelle.
In Figur 1 ist ein Blockschaltbild der erfindungsgemäßen Schaltungsanordnung 10 zur Unterspannungserkennung einer Energiequelle 12 gezeigt. Sowohl die Schaltungsanordung 10 als auch die Energiequelle 12 können sich im Innern eines nicht gezeigten, elektrischen Geräts, beispielsweise eines Elektrowerkzeugs oder dergleichen befinden, wobei die Energiequelle 12 als Akku 14 ausgebildet ist. Es ist zudem möglich, dass die Schaltungsanordung 10 Bestandteil der Energiequelle 12 ist. Mittels eines Umschalters oder Tasters 16 kann die Energiequelle 12 mit der Schaltungsanordnung 10 elektrisch leitend verbunden bzw. von dieser getrennt werden. Befindet sich der Umschalter oder Taster 16 in der unteren Stellung 18, so weist die Versorgungsspannung U am Ausgang der Schaltungsanordnung 10 den Wert Null auf und das elektrische Gerät ist deaktiviert bzw. befindet sich im Ruhezustand.

Durch Verbringen des Umschalters oder Tasters 16 in die obere Stellung 20 wird eine aus einem ersten und einem zweiten Widerstand 22 bzw. 24 sowie einem Kondensator 26 bestehende Reihenschaltung mit der Energiequelle 12 verbunden und der Kondensator 26 über die Widerstände 22 und 24 aufgeladen. Parallel zum ersten Widerstand 22 ist ein als PNP-Bipolartransistor 28 ausgebildetes Schaltmittel 30 derart angeordnet, das sein Emitter E mit dem Umschalter oder Taster 16 verbunden ist, während ein als Basis B ausgelegter Schalteingang 31 an einem Knotenpunkt 32 zwischen dem ersten und dem zweiten Widerstand 22 bzw. 24 liegt, und am Kollektor C die Versorgungsspannung U abgegriffen werden kann. Während des Aufladevorgangs des Kondensators 26 kommt es aufgrund des Ladestroms zu einem Spannungsabfall am Widerstand 22 und demzufolge auch über der Basis-Emitter-Strecke des Bipolartransistors 28. Steigt die Spannung nun soweit an, dass die Schwellspannung des Basis-Emitter-Übergangs überschritten wird, schaltet der PNP-Bipolartransistor 28 durch. Am Ausgang 34 der Schaltungsanordnung 10, der unmittelbar mit dem Kollektor C des PNP-Bipolartransistors 28 verbunden ist, liegt dann die Versorgungsspannung U an, die sich aus der Spannung der Energiequelle 12 abzüglich der Kollektor-Emitter-Spannung des PNP-Bipolartransistors 28 ergibt.

Zwischen dem Kollektor C des PNP-Bipolartransistors 28 und dem Bezugspotential V_ der Energiequelle 12 ist ein Spannungteiler 36 angeordnet, der aus zwei weiteren Widerständen 38 und 40 besteht und über den die Versorgungsspanung U für das elektrische Gerät abgegriffen wird. Parallel zu dem Spannungteiler 36 ist eine aus einem Vorwiderstand 42 und einer Z-Diode 44 bestehende Reihenschaltung angeordnet, wobei über der in Sperrrichtung gepolten Z-Diode 44 eine definierte Zenerspannung U_{Z} abfällt, die als Referenzspannung für die im Folgenden erläuterte Unterspannungserkennung dient. Dazu ist die Basis B eines als NPN-Bipolartransistor 46 ausgebildeten Transistorschalters 48 mit einem Knotenpunkt 50 zwischen den beiden Widerständen 38 und 40 des Spannungsteilers 36 verbunden, während der Emitter E an die Kathode K der Z-Diode 44 und der Kollektor C zwischen dem Kondesator 26 und dem zweiten Widerstand 24 geschaltet ist. Die Widerstände 38 und 40 des Spannungsteilers 36 sind nun derart dimensioniert, dass an dem Knotenpunkt 50 während des normalen Betriebszustands der Schaltungsanordung 10 eine Spannung abfällt, die einen definierten Spannungwert U_{S} überschreitet. Dabei resultiert der definierte Spannungswert Uₛ aus der Summe der Zenerspannung U_{Z} und der Schwellspannung U_{BE} zum Durchschalten des Basis-Emitter-Übergangs des NPN-Bipolartransistors 46.

Kommt es im Laufe des Betriebs des elektrischen Geräts zu einem Absinken der Versorgungsspannung U, beispielsweise infolge einer zu starken Entladung des Akkus 14, so sperrt der NPN-Bipolartransistor 46, falls die über dem Widerstand 40 am Knotenpunkt 50 abfallende Spannung den definierten Spannungswert U_{S} und damit die erforderliche Schwellspannung U_{BE} unterschreitet. Da der Ladevorgang des Kondensators 26 zwischenzeitlich beendet wurde, kann nun kein ausreichender Ladestrom mehr durch den ersten und den zweiten Widerstand 22 bzw. 24 fließen, so dass der Spannungsabfall am ersten Widerstand 22 die zum Durchschalten des Schaltmittels 30 erforderliche Schwellspannung unterschreitet. Das Schaltmittel 30 sperrt daraufhin und bewirkt eine Unterbrechung der Spannungsversorgung am Ausgang 34 der Schaltungsanordnung 10. Durch dieses "Zunullsetzen" der Versorgungsspannung U kann eine Tiefenentladung des Akkus 14 wirksam vermieden werden. Die Schaltungsanordnung 10 befindet sich nunmehr in einem Sperrzustand. Durch die besonders geringe Stromaufnahme der Schaltunganordnung 10 im Sperrzustand ist weiterhin gewährleistet, dass der Akku 14 bei sich in der oberen Stellung 20 befindendem Umschalter oder Taster 16 praktisch nicht belastet wird.

Um die Schaltungsanordnung 10 wieder von dem Sperrzustand in den Betriebszustand zurückzusetzen, ist eine Betätigung des Umschalters oder Tasters 16 erforderlich. Dazu wird dieser zunächst von der oberen Stellung 20 in die untere Stellung 18 verbracht, so dass sich der Kondensator 26 über die beiden Widerstände 22 und 24 entlädt. Wird der Umschalter oder Taster 16 anschließend wieder in die obere Stellung 20 verbracht, so nimmt während des Aufladevorgangs des Kondensators 26 das Schaltmittel 30 - wie oben beschrieben - einen niederohmigen Zustand ein, so dass am Ausgang 34 der Schaltungsanordnung 10 erneut die Versorgungsspannung U anliegt. Der Transistorschalter 48 schaltet jedoch nur durch, wenn die der über dem Widerstand 40 des Spannungsteilers 36 abfallende Anteil der Versorgungsspannung U größer ist als der definierte Spannungswert U_{S}. Ist dies der Fall, so kann die Schaltungsanordnung 10 wieder zur Unterspannungserkennung bzw. -abschaltung der Energiequelle 12 verwendet werden.

Sollte der Akku 14 zwischenzeitlich nicht aufgeladen worden sein, so führt die Betätigung des Umschalters oder Tasters 16 zwar zu einem Durchschalten des Schaltmittels 30 während des Aufladevorgangs des Kondensators 26, der Transistorschalter 48 wird jedoch aufgrund der zu geringen Versorgungsspannung U nicht aktiviert, so dass das Schaltmittel 30 nach Beendigung des Aufladevorgangs des Kondensators 26 wieder sperrt und die Versorgungsspannung U erneut den Wert Null annimmt. Am Ausgang 34 liegt demnach nur kurzzeitig eine Versorgungsspannung U ≠ 0V an. Eine Beeinträchtigung des elektrischen Geräts infolge dieser kurzzeitigen Unterspannung ist jedoch auszuschließen. Das Zurücksetzen der Schaltungsanordnung 10 in den Betriebszustand ist somit nur möglich, wenn der Akku 14 zwischenzeitlich soweit aufgeladen wurde, dass die über den Widerstand 40 des Spannungsteilers 36 abfallende Spannung den definierten Spannungswert U_{S} überschreitet.

Es ist ohne Einschränkung der Erfindung auch möglich, den Umschalter oder Taster 16 während des normalen Betriebsvorgangs, d.h. bei ordnungsgemäßer Spannungsversorgung des elektrischen Geräts, zu betätigen. Wie bereits beschrieben, kommt es hierbei zu einer Entladung des Kondensators 26 über die Widerstände 22 und 24. Im Unterschied zu einer Betätigung des Umschalters oder Tasters 16 während des Sperrzustands werden nun das Schaltmittel 30 und der Transistorschalter 46 vom niederohmigen in den hochohmigen, d.h. sperrenden Zustand verbracht, und die Versorgungsspannung U auf den Wert Null gesetzt. Nach einer erneuten Betätigung des Umschalters oder Tasters 16 von der unteren Stellung 18 in die obere Stellung 20 befindet sich die Schaltungsanordnung 10 wieder im Betriebszustand gemäß der obigen Beschreibung.

Als elektrischen Gerät kann vorzugsweise ein Elektrowerkzeug dienen, in dem die Schaltungsanordnung 10 integriert ist. In diesem Zusammenhang ist es zweckmäßig, wenn der Umschalter oder Taster 16 als ein von außen zugängliches Bedienelement-beispielsweise der Ein/Aus- oder Hauptschalter - des Elektrowerkzeugs ausgebildet ist. Dabei sollte die untere Stellung 18 des Umschalters oder Tasters 16 einer Ruhestellung des Bedienelements entsprechen, während dessen Betätigung einem Verbringen in die obere Stellung 20 gleichkommt. Ist das elektrische Gerät beispielsweise ein Akkuschrauber, so wird durch Betätigen und Gedrückhalten des Ein/Aus-Schalters ein Elektromotor mit Energie versorgt. Erkennt die Schaltungsanordnung 10 nun während des Betriebs oder unmittelbar nach Betätigung des Ein/Aus-Schalters eine Unterspannung der an dem Elektromotor anliegenden Versorgungsspannung U, so setzt sie diese in der oben beschriebenen Weise auf den Wert Null. Auf diesen Vorgang kann der Benutzer des Akkuschraubers beispielsweise durch eine LED oder ein anderes Anzeigemittel hingewiesen werden. Lässt der Benutzer den Ein/Aus-Schalter wieder los, wird er in die unter Stellung 18 verbracht und die Schaltungsanordnung 10 gemäß der obigen Beschreibung zurückgesetzt.

Es ist möglich, die Schaltungsanordnung 10 als Bestandteil des elektrischen Geräts oder der Energiequelle 12 auszubilden. Im letzteren Fall ist es zweckmäßig, dass die Energiequelle 12 entsprechend ausgebildete Kontakte aufweist zur Verbindung der Schaltungsanordnung 10 mit dem Umschalter oder Taster 16 des elektrischen Geräts. Hierauf kann jedoch verzichtet werden, wenn sich der Umschalter oder Taster 16 ebenfalls an der Energiequelle 12 befindet. Auch das oben erwähnte Anzeigemittel kann am elektrischen Gerät und/oder an der Energiequelle 12 angeordnet sein.

Es sei abschließend noch darauf hingewiesen, dass auf die Angabe exakter Werte für die Bauelemente der Schaltungsanordnung 10 verzichtet wurde, da diese unter anderem von dem Energiebedarf des elektrischen Geräts und demzufolge von der Belastbarkeit abhängen. Ein Fachmann auf dem Gebiet des Elektrotechnik wird in der Lage sein, die Bauelemente entsprechend zu dimensonieren. Weiterhin ist es möglich, dass weitere Schaltmittel 30 als ein Relais auszubilden. Bei besonders hohen Leistungsanforderungen können auch Insulated-Gate-Bipolartransistoren (IGBT) als Transistorschalter 48 bzw. weiteres Schaltmittel 30 zum Einsatz kommen. Auch eine Verwendung von entsprechend ausgelegten Feldeffekt-Transistoren ist denkbar.

## Patentansprüche

1. Schaltunganordnung (10) zur Unterspannungserkennung einer Energiequelle (12), mit einem Transistorschalter (48) und zumindest einem weiteren Schalter (30), wobei der Transistorschalter (48) und der weitere Schalter (30) in einem Betriebszustand der Schaltungsanordung (10) niederohmig sind und der Transistorschalter (48) den weiteren Schalter (30) zur Unterbrechung der Spannungsversorgung sperrt, wenn eine Versorgungsspannung (U) der Energiequelle (12) einen definierten Spannungswert (U_{S}) unterschreitet, **dadurch gekennzeichnet, dass** der definierte Spannungswert (U_{S}) aus der Summe einer Zenerspannung (U_{Z}) einer Z-Diode (44) und einer Schwellspannung (U_{BE}) des Transistorschalters (48) gebildet ist und dass der Transistorschalter (48) und die Z-Diode (44) dem weiteren Schalter (30) energiequellenseitig nachgeschaltet sind.

2. Schaltungsanordnung (10) nach Anspruch 1, **dadurch gekennzeichnet, dass** der Transistorschalter (48) mit einem Spannungteiler (36) verbunden ist zur Überwachung der Versorgungsspannung (U).

3. Schaltungsanordnung (10) nach Anspruch 2, **dadurch gekennzeichnet, dass** der Transistorschalter (48) sperrt, wenn die mittels des Spannungsteilers (36) überwachte Versorgungsspannung (U) unter den definierten Spannungswert (Us) fällt.

4. Schaltungsanordnung (10) nach einem der vorhergehenden Ansprüche, **dadurch gekennzeichnet, dass** der Transistorschalter (48) ein NPN-Bipolartransistor (46) ist, wobei die Basis (B) des NPN-Bipolartransistors (46) mit dem Spannungsteiler (36), der Emitter (E) des NPN-Bipolartransistors (46) mit der Kathode (K) der Z-Diode (44) und der Kollektor (C) des NPN-Bipolartransistors (46) über einen Widerstand (24) mit einem Schalteingang (31) des weiteren Schalters (30) derart verbunden ist, um den Schalter (30) über den Schalteingang (31) in den ein- oder ausgeschalteten Zustand umzuschalten.

5. Schaltungsanordung (10) nach Anspruch 1, **dadurch gekennzeichnet, dass** die Schaltungsanordnung mittels eines Umschalters oder Tasters (16) in den Betriebszustand zurücksetzbar ist.

6. Schaltungsanordnung (10) nach einem der vorhergehenden Ansprüche, **dadurch gekennzeichnet, dass** das zumindest eine weitere Schaltmittel (30) als ein PNP-Bipolartransistor (28) oder ein Relais ausgebildet ist.

7. Energiequelle (12) mit einer Schaltungsanordnung (10) nach einem der vorhergehenden Ansprüche 1 bis 6.

8. Energiequelle (12) nach Anspruch 7, **dadurch gekennzeichnet, dass** die Energiequelle (12) ein Akku (14) ist.

9. Elektrisches Gerät mit einer Schaltungsanordnung (10) nach einem der Ansprüche 1 bis 6.

10. Elektrisches Gerät nach Anspruch 9, **dadurch gekennzeichnet, dass** das elektrische Gerät ein Elektrowerkzeug ist.

## Claims

1. Circuit arrangement (10) for undervoltage identification of an energy source (12), having a transistor switch (48) and at least one further switch (30), wherein the transistor switch (48) and the further switch (30) have a low impedance in an operating state of the circuit arrangement (10) and the transistor switch (48) turns off the further switch (30) in order to interrupt the voltage supply when a supply voltage (U) of the energy source (12) falls below a defined voltage value (U_{S}), **characterized in that** the defined voltage value (U_{S}) is formed from the sum of a Zener voltage (U_{Z}) of a Zener diode (44) and a threshold voltage (U_{BE}) of the transistor switch (48) and **in that** the transistor switch (48) and the Zener diode (44) are connected downstream of the further switch (30) on the energy source side.

2. Circuit arrangement (10) according to Claim 1, **characterized in that** the transistor switch (48) is connected to a voltage divider (36) in order to monitor the supply voltage (U).

3. Circuit arrangement (10) according to Claim 2, **characterized in that** the transistor switch (48) turns off when the supply voltage (U) monitored by means of the voltage divider (36) falls below the defined voltage value (Us).

4. Circuit arrangement (10) according to one of the preceding claims, **characterized in that** the transistor switch (48) is an NPN bipolar transistor (46), wherein the base (B) of the NPN bipolar transistor (46) is connected to the voltage divider (36), the emitter (E) of the NPN bipolar transistor (46) is connected to the cathode (K) of the Zener diode (44) and the collector (C) of the NPN bipolar transistor (46) is connected by means of a resistor (24) to a switching input (31) of the further switch (30) in such a way as to change over the switch (30) to the switched-on or switched-off state by means of the switching input (31).

5. Circuit arrangement (10) according to Claim 1, **characterized in that** the circuit arrangement can be reset to the operating state by means of a changeover switch or button (16).

6. Circuit arrangement (10) according to one of the preceding claims, **characterized in that** the at least one further switching means (30) is designed as a PNP bipolar transistor (28) or a relay.

7. Energy source (12) having a circuit arrangement (10) according to one of the preceding Claims 1 to 6.

8. Energy source (12) according to Claim 7, **characterized in that** the energy source (12) is a rechargeable battery (14).

9. Electrical device having a circuit arrangement (10) according to one of Claims 1 to 6.

10. Electrical device according to Claim 9, **characterized in that** the electrical device is a power tool.

## Revendications

1. Arrangement de circuit (10) destiné à détecter une sous-tension d'une source d'énergie (12), comprenant un commutateur à transistor (48) et au moins un commutateur supplémentaire (30), le commutateur à transistor (48) et le commutateur supplémentaire (30) étant à faible impédance dans un état opérationnel de l'arrangement de circuit (10) et le commutateur à transistor (48) bloquant le commutateur supplémentaire (30) en vue d'interrompre l'alimentation électrique lorsqu'une tension d'alimentation (U) de la source d'énergie (12) devient inférieure à une valeur de tension définie (U_{S}), **caractérisé en ce que** la valeur de tension définie (U_{S}) est formée par la somme d'une tension de zener (U_{Z}) d'une diode zener (44) et d'une tension de seuil (U_{BE}) du commutateur à transistor (48) et **en ce que** le commutateur à transistor (48) et la diode zener (44) sont branchés en aval du commutateur supplémentaire (30) du côté de la source d'énergie.

2. Arrangement de circuit (10) selon la revendication 1, **caractérisé en ce que** le commutateur à transistor (48) est relié à un diviseur de tension (36) pour la surveillance de la tension d'alimentation (U).

3. Arrangement de circuit (10) selon la revendication 2, **caractérisé en ce que** le commutateur à transistor (48) se bloque lorsque la tension d'alimentation (U) surveillée au moyen du diviseur de 'tension (36) devient inférieure à la valeur de tension définie (U_{S}).

4. Arrangement de circuit (10) selon l'une des revendications précédentes, **caractérisé en ce que** le commutateur à transistor (48) est un transistor bipolaire NPN (46), la base (B) du transistor bipolaire NPN (46) étant reliée au diviseur de tension (36), l'émetteur (E) du transistor bipolaire NPN (46) à la cathode (K) de la diode zener (44) et le collecteur (C) du transistor bipolaire NPN (46) par le biais d'une résistance (24) à l'entrée de commutation (31) du commutateur supplémentaire (30) de manière à permuter le commutateur (30) dans l'état en circuit ou hors circuit par le biais de l'entrée de commutation (31).

5. Arrangement de circuit (10) selon la revendication 1, **caractérisé en ce que** l'arrangement de circuit peut être réinitialisé dans l'état opérationnel au moyen d'un inverseur ou d'un bouton-poussoir (16).

6. Arrangement de circuit (10) selon l'une des revendications précédentes, **caractérisé en ce que** l'au moins un moyen de commutation supplémentaire (30) est réalisé sous la forme d'un transistor bipolaire PNP (28) ou d'un relais.

7. Source d'énergie (12) comprenant un arrangement de circuit (10) selon l'une des revendications précédentes 1 à 6.

8. Source d'énergie (12) selon la revendication 7, **caractérisée en ce que** la source d'énergie (12) est un accumulateur (14).

9. Appareil électrique pourvu d'un arrangement de circuit (10) selon l'une des revendications 1 à 6.

10. Appareil électrique selon la revendication 9, **caractérisé en ce que** l'appareil électrique est un outil électrique.
